# EUROPEAN PATENT APPLICATION

(11) **EP 4 369 014 A1**
(43) Date of publication of application: **15.05.2024**
(21) Application number: 22837685.1
(22) Date of filing: 05.07.2022
(51) Int. Cl.: G01R 33/032, G01R 15/24, G01R 33/02

(54) **MAGNETIC FIELD SENSOR HEAD AND MAGNETIC FIELD SENSOR DEVICE**

(30) Priority: 05.07.2021 JP 2021111731
(71) Applicant: CITIZEN FINEDEVICE CO., LTD., Minamitsuru-gun, Yamanashi 401-0395 (JP); Citizen Watch Co., Ltd., Nishitokyo-shi, Tokyo 188-8511 (JP)
(72) Inventor: MIYAMOTO, Mitsunori, Minamitsuru-gun, Yamanashi 401-0395 (JP); NOZAKI, Takaaki, Nishitokyo-shi, Tokyo 188-8511 (JP); SOGA, Yoshihiko, Minamitsuru-gun, Yamanashi 401-0395 (JP)
(74) Representative: Ricker, Mathias
(86) International application number: PCT/JP2022/026766
(87) International publication number: WO 2023/282271

(57) **Abstract**

A magnetic field sensor head detects a magnetic field occurring when a current flows through a conductor, and has an optical fiber having a magnetic film arranged on the end surface and a reflective film arranged on the magnetic film; and a magnetic material arranged in the form of a ring around a conductor and containing the magnetic film, wherein the magnetic material has a first taper portion formed so that a cross-sectional area perpendicular to the orientation of the magnetic flux becomes smaller as approaching the magnetic film in order to concentrate a magnetic flux occurring when a current flows through a conductor on an area in which the magnetic film is arranged.

## Description

### FIELD

The present invention relates to a magnetic field sensor head and a magnetic field sensor device.

### BACKGROUND

A magnetic field sensor device has been reported, which measures a current value by utilizing the Faraday effect of a metallic magnetic material (for example, see Japanese Unexamined Patent Publication No. 2018-28499). The magnetic field sensor device described in Japanese Unexamined Patent Publication No. 2018-28499 has an optical fiber and a magnetic field sensor element provided on the end surface of the optical fiber and having a light transmitting film including a metallic magnetic material and a reflective film provided on the light transmitting film.

The conventional magnetic field sensor device measures a current flowing through a conductor by putting the conductor close to the light transmitting film including the metallic magnetic material provided at the end portion of the magnetic field sensor element.

### SUMMARY

However, in the conventional magnetic field sensor device, the strength of the magnetic field that occurs when a current flows through the conductor decreases in inverse proportion to the distance from the conductor, and therefore when the position of the conductor shifts with respect to the position of the magnetic field sensor element provided at the end portion of the optical fiber, the magnetic field strength detected by the magnetic field sensor element may vary, and therefore it is difficult to measure the current flowing through the conductor with accuracy.

An object of the present disclosure is to provide a magnetic field sensor head capable of measuring the magnitude of a current flowing through a conductor with accuracy even if the position of the conductor shifts with respect to the position of an optical fiber at the end portion of which a magnetic field sensor element is provided.

A magnetic field sensor head according to the present disclosure detects a magnetic field occurring when a current flows through a conductor, and has an optical fiber having a magnetic film arranged on the end surface and a reflective film arranged on the magnetic film; and a magnetic material arranged in the form of a ring around a conductor and containing the magnetic film, wherein the magnetic material has a first taper portion formed so that a cross-sectional area perpendicular to the orientation of the magnetic flux becomes smaller as approaching the magnetic film in order to concentrate a magnetic flux occurring when a current flows through a conductor on an area in which the magnetic film is arranged.

It is preferable for the magnetic field sensor head according to the present disclosure that the first taper portion has a structure formed into the shape of a cone or a pyramid.

It is preferable for the magnetic field sensor head according to the present disclosure that the magnetic material includes amorphous iron powder solidified with resin.

It is preferable for the magnetic field sensor head according to the present disclosure that the magnetic material further has a second taper portion arranged facing the first taper portion and formed so that a cross-sectional area perpendicular to the orientation of the magnetic flux becomes smaller as approaching the magnetic film.

It is preferable for the magnetic field sensor head according to the present disclosure to further have a first member and a second member holding the magnetic material, and the first member and the second member are formed movable relatively so that a gap is formed between magnetic materials divided into plurality in order to arrange a conductor on the inner circumferential side of the magnetic materials.

It is preferable for the magnetic field sensor head according to the present disclosure to further have a support portion supporting the optical fiber, the first member and the second member fit to the support portion and at least one of the first member and the second member is arranged slidable along the support portion.

It is preferable for the magnetic field sensor head according to the present disclosure that the first member and the second member are formed of silicon and the support portion is formed of ceramics.

It is preferable for the magnetic field sensor head according to the present disclosure that the first member and the second member are each provided with an elastic locking portion and the elastic locking portion is provided with an elastic member on which a force causing the elastic member to return to the original position is exerted when the first member and the second member are slid relatively.

A magnetic field sensor device according to the present disclosure has a magnetic field sensor head according to any one of the above magnetic field sensor heads, a light emitting device introducing linearly polarized light into an optical fiber as incident light, and a light receiving device separating return light reflected from a reflective film and derived from the optical fiber into an S polarized light component and a P polarized light component, receiving the S polarized light component and the P polarized light component, converting the S polarized light component and the P polarized light component into electric signals, and processing the electric signals.

According to the magnetic field sensor head of one embodiment of the present disclosure, even if the position of a conductor shifts with respect to the position of an optical fiber at the end portion of which a magnetic field sensor element is provided, the magnitude of a current flowing through the conductor may be measured with accuracy.

### BRIEF DESCRIPTION OF THE DRAWINGS

FIG. 1 shows a perspective diagram of a magnetic field sensor head according to the first embodiment;
FIG. 2 shows a schematic configuration diagram of a magnetic field sensor device using the magnetic field sensor head 101 according to the first embodiment;
FIG. 3 shows a cross-sectional diagram along an A-A line in FIG. 1;
FIG. 4 shows an enlarged diagram of an area B in FIG. 3;
FIG. 5A to FIG. 5D show diagrams for explaining a procedure to insert the conductor into the magnetic field sensor head according to the first embodiment;
FIG. 6 shows a perspective diagram of the magnetic field sensor head according to the second embodiment;
FIG. 7 shows a cross-sectional diagram along an C-C line in FIG. 6; and
FIG. 8A to FIG. 8D show diagrams for explaining a procedure to insert the conductor into the magnetic field sensor head according to the second embodiment.

### DESCRIPTION OF EMBODIMENTS

In the following, with reference to the drawings, the magnetic field sensor head and the magnetic field sensor device according to the present invention are explained. However, it should be noted that the technical scope of the present invention is not limited to those embodiments but encompasses the invention described in the claims and the equivalents thereof.

### [First Embodiment]

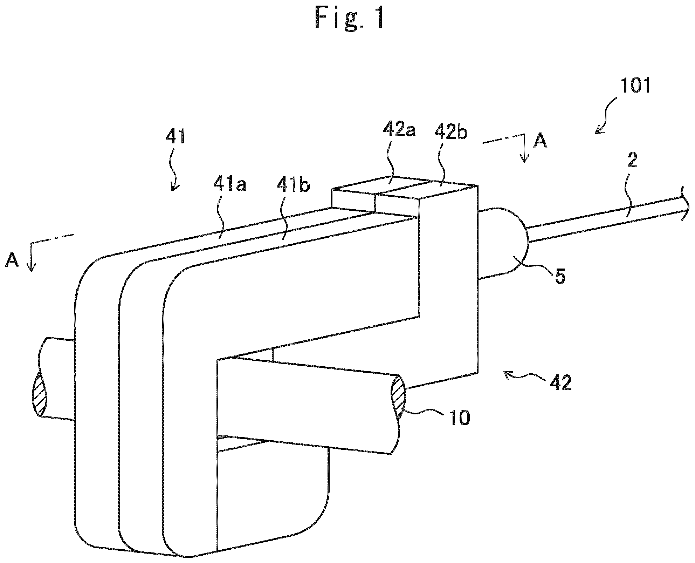

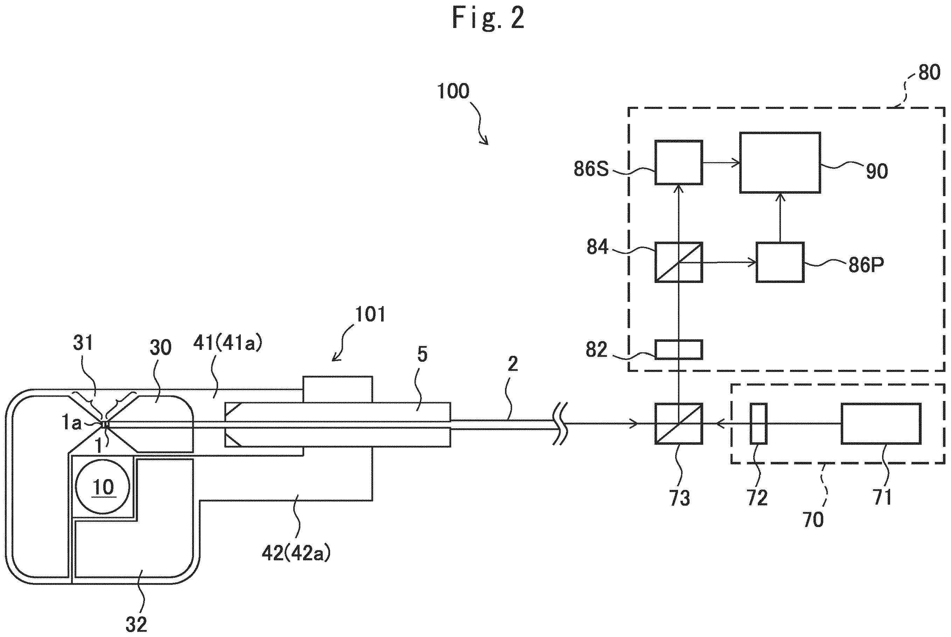

First, a magnetic field sensor head according to a first embodiment of the present disclosure is explained. FIG. 1 shows a perspective diagram of a magnetic field sensor head 101 according to the first embodiment. FIG. 2 shows a schematic configuration diagram of a magnetic field sensor device 100 using the magnetic field sensor head 101 according to the first embodiment.

The magnetic field sensor device 100 using the magnetic field sensor head 101 according to the first embodiment of the present disclosure has the magnetic field sensor head 101, a light emitting device 70, and a light receiving device 80 as shown in FIG. 2. The magnetic field sensor head 101 has an optical fiber 2, a magnetic film 1 provided on the end surface of the optical fiber 2, a reflective film 1a provided on the magnetic film 1, a first magnetic material 30, and a second magnetic material 32.

The light emitting device 70 has a light emitting element 71 and a polarizer 72. The light receiving device 80 has a polarizer 82, a polarization separation element 84, light receiving elements (86S, 86P) and a signal processing unit 90.

The magnetic field sensor device 100 further has a half mirror 73. The half mirror 73 functions so as to send light returned from the magnetic field sensor head 101 to the light receiving device 80 as well as introducing light from the light emitting device 70 into the optical fiber 2.

In the magnetic field sensor device 100, the plane of polarization of light having propagated through the optical fiber 2 rotates by the Faraday effect of the magnetic film 1 in accordance with the magnetic field strength. Thus, the magnetic field that occurs when a current flows through a conductor 10 may be detected by detecting the amount of rotation of the plane of polarization.

In the magnetic field sensor head 101, when linearly polarized light is propagated by the optical fiber 2 and the propagated linearly polarized light enters the magnetic film 1, the plane of polarization rotates by the Faraday effect of the magnetic film 1. The light whose plane of polarization has rotated propagates to the optical fiber 2 as return light and is separated into a P polarized light component and an S polarized, and the intensity of each polarized light is found by the light receiving elements (86S, 86P). In the signal processing unit 90, a circuit detects a difference between the intensities of the two polarized lights from the photoelectrically converted electric signals, and the numerical value thereof is converted into a current value.

When a current flows through the conductor 10, a magnetic field occurs around the conductor 10 and by measuring the magnetic field, the magnitude of the current flowing through the conductor 10 may be measured.

In the following, each component of the magnetic field sensor head is explained in detail.

As shown in FIG. 2, the magnetic field sensor head 101 is a magnetic field sensor head that detects the magnetic field that occurs when a current flows through the conductor 10 and has the optical fiber 2, the magnetic film 1 provided on the end surface of the optical fiber 2, the reflective film 1a provided on the magnetic film 1, the first magnetic material 30, and the second magnetic material 32.

As shown in FIG. 2, the magnetic film 1 is provided on the end surface on the front end side of the optical fiber 2. It is preferable for the magnetic film 1 to be provided at the end portion of the optical fiber 2 whose end surface has been processed into a flat surface. The magnetic film 1 acts so as to rotate the plane of polarization of the linearly polarized light propagated through the optical fiber 2 by the Faraday effect. Although Fe, Co, Ni, FeNi alloy, FeCo alloy, FeNiCo alloy, NiCo alloy, magnetic garnet film, such as YIG, granular film and etc., may be used as the magnetic film 1, the magnetic film 1 is not limited to those.

The reflective film 1a is a mirror element that reflects light transmitting the magnetic film 1 toward the magnetic film 1. The reflective film 1a emits circularly polarized light whose rotation direction is opposite to that of circularly polarized light having transmitted the optical fiber 2 to the magnetic film 1. A silver film, gold film, aluminum film, dielectric multilayer film mirror and etc., may be used as the reflective film 1a. In particular, a silver film whose reflectance is high and a gold film whose resistance to corrosion is high are preferable. Although the thickness of the reflective film 1a is not limited, reflectance thereof may be high for example, 98% or more, and for example, it is preferable for the thickness of the reflective film 1a to be not less than 50 nm and not more than 200 nm, when the reflective film 1a is a silver film. The Faraday rotation angle may be increased, by causing light to reciprocate within the magnetic film 1 by using the reflective film 1a.

The first magnetic material 30 and the second magnetic material 32 are arranged in the form of a ring around the conductor 10 and contains the magnetic film 1. The first magnetic material 30 and the second magnetic material 32 may contain amorphous iron powder solidified with resin. For example, although ferrite, dust core, amorphous foil, sintered soft magnetic material and etc., may be used as the amorphous iron powder, the amorphous iron powder is not limited to those examples. It is preferable for the amorphous iron powder to have a particle diameter of about 10 microns. The surface of the amorphous iron powder is covered with an oxide film and each iron powder particle is isolated from one another. Thus, even if a high-frequency current flows through the conductor 10, no currents flow through the amorphous iron powder, and therefore eddy current loss in a high-frequency band which predominates in the iron loss may be suppressed.

The insides of a first member 41 and a second member 42 configuring the magnetic field sensor head 101 may be filled with the first magnetic material 30 and the second magnetic material 32, respectively. The first member 41 and the second member 42 may be formed by, for example, etching silicon. The first member 41 is separated into a first member 41a on one side and a first member 41b on the other side and a concave portion provided in each of the first member 41a and the first member 41b may be filled with the first magnetic material 30. In other words, spaces for holding the first magnetic material 30 are formed by the concave portions, by causing the surface of the first member 41a on one side in which the concave portion is formed and the surface of the first member 41b on the other side in which the concave portion is formed to face each other. Similarly, the second member 42 is separated into a second member 42a on one side and a second member 42b on the other side, and a concave portion provided in each of the second member 42a and the second member 42b may be filled with the second magnetic material 32. The concave portions may be formed into any shape, and the cross section cut by a plane perpendicular to the circumferential direction of the first magnetic material 30 and the second magnetic material 32 may be formed into the shape of a rectangle or circle in accordance with the shape of the concave portion.

After the concave portions are filled with the first magnetic material 30 and the second magnetic material 32, by integrating the first member 41a on one side and the first member 41b on the other side into one member, the first magnetic material 30 may be held in the first member 41. Similarly, after the concave portions are filled with the first magnetic material 30 and the second magnetic material 32, by integrating the second member 42a on one side and the second member 42b on the other side into one member, the second magnetic material 32 may be held in the second member 42.

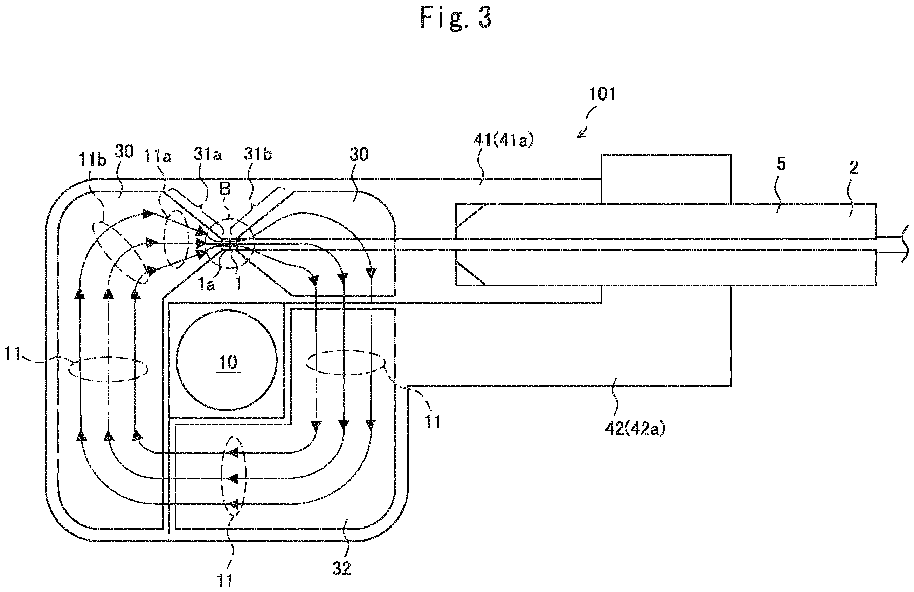

FIG. 3 shows a cross-sectional diagram along an A-A line in FIG. 1. When a current flows through the conductor 10 in the direction perpendicular to the paper surface from the front side toward the rear side, a magnetic flux 11 occurs in the clockwise direction as shown by arrows in FIG. 3. It is preferable for the first magnetic material 30 and the second magnetic material 32 to be configured by a material whose relative permeability is higher than that of the first member 41 and the second member 42. The relative permeability is about 20, when the first magnetic material 30 and the second magnetic material 32 are configured by amorphous iron powder. The magnetic flux 11 that occurs around the conductor 10 is distributed in the first magnetic material 30 and the second magnetic material 32 whose relative permeability is high, and therefore when the shape of the first magnetic material 30 is formed into the shape of a taper, the magnetic flux 11 concentrates on and is distributed in the area formed into the shape of a taper.

Thus, it is preferable for the first magnetic material 30 to have a first taper portion 31a and a second taper portion 3 1b formed so that the cross-sectional area perpendicular to the orientation of the magnetic flux becomes smaller as they approach the magnetic film 1 in order to concentrate the magnetic flux 11 on the area in which the magnetic film 1 is arranged, which occurs when a current flows through the conductor 10.

For example, as shown in FIG. 3, when the first magnetic material 30 is formed into the shape of a taper so that the cross-sectional area perpendicular to the orientation of the magnetic flux 11 becomes smaller toward the area in which the magnetic film 1 is arranged in the first taper portion 31a, a magnetic flux 11a in the first taper portion 31a converges more compared to a magnetic flux 11b before the first taper portion 31a. Thus, much flux may be concentrated on the magnetic film 1, by providing the first taper portion 31a.

Therefore, whereas only the magnetic flux reaching the area about the size of one optical fiber to the magnetic film is conventionally collected, according to the magnetic field sensor head 101 of the first embodiment of the present disclosure, the magnetic flux in a wider range to the magnetic film 1 may be collected, and therefore the amount of the measured magnetic flux may be increased and the accuracy of measurement may be improved.

The second taper portion 31b is arranged so as to face the first taper portion 31a. Since the second taper portion 31b is arranged with the first taper portion 31a, even if the magnetic flux 11 occurs in the clockwise direction or in the counterclockwise direction, much magnetic flux on the magnetic film 1 may be concentrated.

Further, when the diameter of the conductor 10 is smaller than the inside diameter of the opening accommodating the conductor provided in the magnetic field sensor head 101, the position of the conductor 10 is not fixed. Thus, when the position of the conductor 10 moves in the inner circumferential portion of the magnetic field sensor head 101, the strength of the magnetic field that occurs by a current flowing through the conductor 10 varies at the position at which the magnetic film 1 is provided. On the other hand, according to the magnetic field sensor head 101 of the first embodiment of the present disclosure, the first taper portion 31a and the second taper portion 31b in the first magnetic material 30 and the second magnetic material 32 are provided, and the magnetic flux caused to converge by the first taper portion 31a and the second taper portion 3 1b is detected, and therefore the magnetic film 1 may detect the averaged magnetic flux 11 passing through the first magnetic material 30 and the second magnetic material 32. Thus, even if the diameter of the conductor 10 is smaller than the inside diameter of the opening provided in the magnetic field sensor head 101, the variations of the magnetic field strength due to the variations of the position of the conductor 10 is suppressed, and therefore the accuracy of the measured value of the current flowing through the conductor 10 may be improved. Further, the variations of the measured values by the position of the conductor 10 may be mitigated by shifting the center of the hole through which the conductor 10 passes so that the hole becomes distant from the magnetic film 1 (optical fiber 2).

Although the magnetic flux converges on the magnetic film 1, if the convergence spreads toward one of the directions, the convergence rate and the sensitivity may be reduced. Thus, it is important to form the first taper portion 31a and the second taper portion 31b bilaterally symmetrical so that the convergence of the magnetic flux becomes substantially uniform. However, a detailed examination indicates that the uniformity is not obtained because the first magnetic material 30 on the side on which the optical fiber 2 is provided lacks the magnetic material corresponding to the portion at which the optical fiber 2 is provided. On the other hand, it is considered that the sensitivity improves on the whole by also thickening the opposite side than by making the magnetic flux uniform by thickening the first magnetic material 30 on the side on which the optical fiber 2 is provided, although the uniformity is not obtained. In view of the above points, it is considered preferable to form the first taper portion 31a and the second taper portion 3 1b into a bilaterally symmetrical shape.

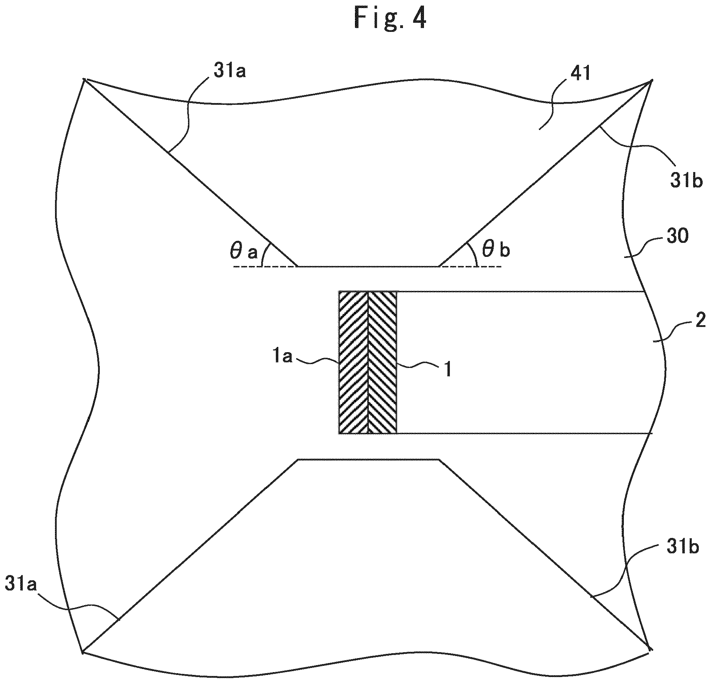

FIG. 4 shows an enlarged diagram of an area B in FIG. 3. As described above, it is preferable for the first taper portion 31a and the second taper portion 31b to be formed bilaterally symmetrical with the magnetic film 1 being sandwiched in between. Thus, it is preferable for an angle θa formed by the first taper portion 31a and the horizontal plane and an angle θb formed by the second taper portion 31b and the horizontal plane to be equal.

It is preferable for the first taper portion 31a and the second taper portion 31b to have a structure formed into the shape of a cone or pyramid. For example, when the shape of the cross section cut by a plane perpendicular to the direction of the magnetic field of the first magnetic material 30 and the second magnetic material 32 is a rectangle, the shape of the first taper portion 31a and the second taper portion 31b may be formed into the shape of a quadrangular pyramid. Further, when the shape of the cross section cut by a plane perpendicular to the direction of the magnetic field of the first magnetic material 30 and the second magnetic material 32 is a circle or ellipse, the shape of the first taper portion 31a and the second taper portion 31b may be formed into the shape of a cone. However, the examples are not limited and even if the shape of the cross section cut by a plane perpendicular to the direction of the magnetic field of the first magnetic material 30 and the second magnetic material 32 is a rectangle, the first taper portion 31a may be formed so that the shape of the cross section becomes a circle toward the magnetic film 1.

In order to measure a current flowing through the conductor 10, it is necessary to arrange the first magnetic material 30 and the second magnetic material 32 around the conductor 10. Thus, it is preferable for the magnetic field sensor head 101 according to the first embodiment of the present disclosure to have the first member 41 and the second member 42 holding the first magnetic material 30 and the second magnetic material 32 in order to make part of the first magnetic material 30 and the second magnetic material 32 movable, and for the first member 41 and the second member 42 to be formed movable relatively so that a gap is formed between the first magnetic material 30 and the second magnetic material 32 divided into plurality in order to arrange the conductor 10 on the inner circumferential side of the first magnetic material 30 and the second magnetic material 32.

It is preferable for the magnetic field sensor head 101 to further have a support portion 5 formed of ceramics and supporting the optical fiber 2, since the first member 41 and the second member 42 may fit into the support portion 5, and at least one of the first member 41 and the second member 42 may be arranged slidably along the support portion 5. Since the support portion 5 is formed of ceramics, compared to a case where the support portion 5 is formed of a synthetic resin, such as polyimide, the wear is suppressed, which is caused by sliding with the second member 42 in a case where the operation to accommodate the conductor 10 in the inner circumferential portion of the magnetic field sensor head 101 is repeated. Since the support portion 5 is formed of ceramics, the wear is suppressed, and therefore the possibility is faint that the fitting with the second member 42 becomes loose by the repetition of the operation to accommodate the conductor 10 and the position of the magnetic film arranged on the end surface of the magnetic field sensor head 101 shifts, and therefore the measurement accuracy is reduced. As shown in FIG. 1, it is preferable to form the cross-sectional shape of the first member 41 and the second member 42 into the shape of a rectangle. The first member 41 and the second member 42 slides on the same plane, and therefore the first member 41 and the second member 42 is prevented from rotating about the axis of the support portion 5, by forming the cross-sectional shape into the shape of a rectangle.

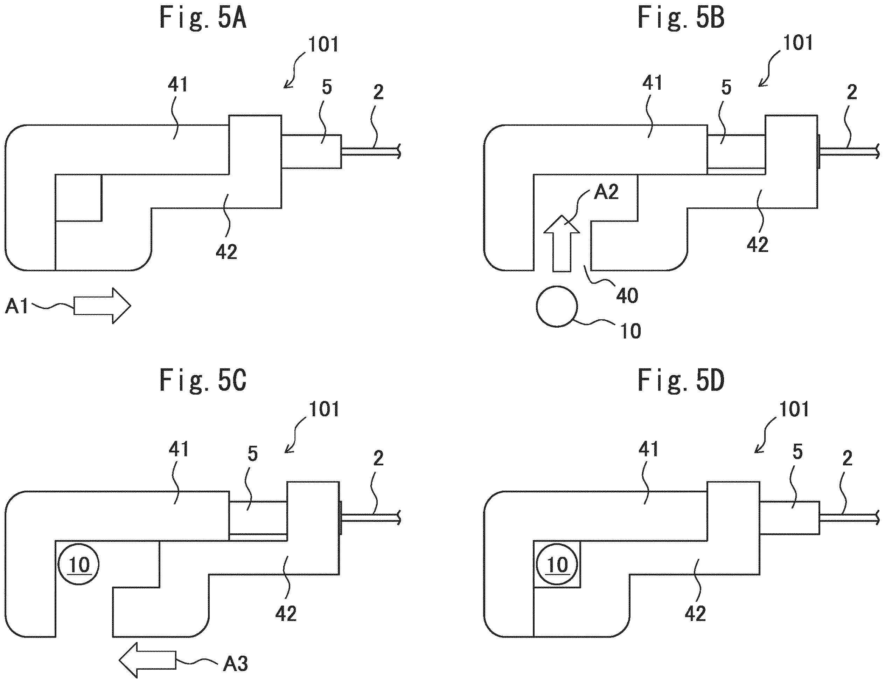

FIG. 5A to 5D show diagrams for explaining a procedure to insert the conductor 10 into the magnetic field sensor head 101 according to the first embodiment. FIG. 5A shows a first state, FIG. 5B shows a second state, FIG. 5C shows a third state, and FIG. 5D shows a fourth state. As one example, explanation is given by taking a case as an example where the first member 41 is fixed and the second member 42 is slidable. First, as shown in FIG. 5A, the second member 42 is moved in the direction of an arrow A1.

Then, as shown in FIG. 5B, a gap 40 having a width greater than the diameter of the conductor 10 is formed between the first member 41 and the second member 42. Next, the conductor 10 is moved in the direction indicated by an arrow A2 and the conductor is accommodated in the inner circumferential portion of the magnetic field sensor head 101.

Next, as shown in FIG. 5C, after the conductor 10 is accommodated in the inner circumferential portion of the magnetic field sensor head 101, the second member 42 is moved in the direction indicated by an arrow A3.

Next, as shown in FIG. 5D, the second member 42 is moved to the original position and the series of operations is completed. As shown in FIG. 4, the insides of the first member 41 and the second member 42 is filled with the first magnetic material 30 and the second magnetic material 32, and therefore the first magnetic material 30 and the second magnetic material 32 may be arranged around the conductor 10.

As described above, since the first member 41 or the second member 42 is movable, even if it is difficult to accommodate the conductor 10 in the inner circumferential portion of the magnetic field sensor head 101, such as a case where the conductor 10 is an already installed wire and etc., the conductor 10 may be accommodated in the inner circumferential portion of the magnetic field sensor head 101, and therefore, the first magnetic material 30 and the second magnetic material 32 may be arranged around the conductor 10.

Although, the example in which the first member 41 is fixed and the second member 42 slides in the example shown in FIG. 5A to FIG. 5D is explained, the example is not limited to the example shown therein. For example, the second member 42 may be fixed and the first member 41 may be slid, or both the first member 41 and the second member 42 may be slid.

### [Second Embodiment]

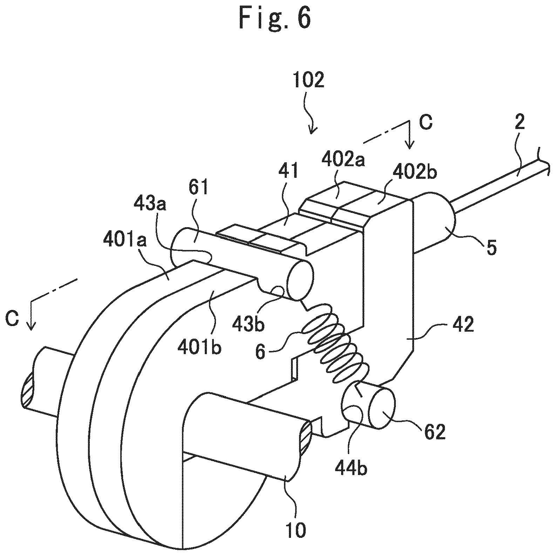

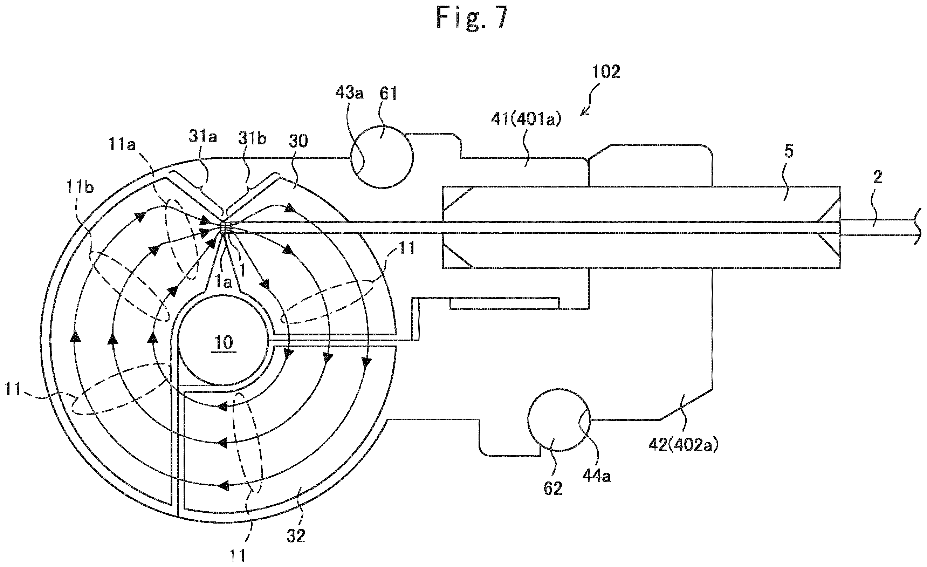

Next, a magnetic field sensor head 102 according to a second embodiment of the present disclosure is explained. FIG. 6 shows a perspective diagram of the magnetic field sensor head 102 according to the second embodiment. FIG. 7 shows a cross-sectional diagram along a C-C line in FIG. 6. The magnetic field sensor head 102 according to the second embodiment differs from the magnetic field sensor head 101 according to the first embodiment in that the first member 41 and the second member 42 are respectively provided with elastic locking portions (61, 62) and the elastic locking portions (61, 62) are provided with an elastic member 6 on which a force is exerted, which causes the elastic member 6 to return to its original position when the first member 41 and the second member 42 are slid relatively. The other configurations of the magnetic field sensor head 102 according to the second embodiment are the same as those of the magnetic field sensor head 101 according to the first embodiment, and therefore, detailed explanation is omitted.

In the magnetic field sensor head 102 according to the second embodiment, the first member 41 and the second member 42 are connected each other by the elastic member 6. A coil spring, rubber and etc., may be used as the elastic member 6. Although, in FIG. 6, the elastic member 6 is provided only on the front side of the first member 41 and the second member 42, the elastic member 6 may be provided on the backside.

The elastic member 6 is locked to the first member 41 and the second member 42 by the elastic locking portions (61, 62). It is preferable for the elastic locking portion 61 to be provided rotatably in concave portions (43a, 43b) provided in the first member 41. Similarly, it is preferable for the elastic locking portion 62 to be provided rotatably in a concave portions (44a (see FIG. 7), 44b) provided in the second member 42. Since the elastic locking portions (61, 62) in the first member 41 and the second member 42 are rotatably provided, even if the first member 41 and the second member 42 move relatively and the elastic member 6 expands and contracts, the stress acting between the elastic locking portions (61, 62) and the elastic member 6 may be reduced.

Further, a ring-shaped elastic member may be used as the elastic member 6 and the ring-shaped elastic member may be arranged so as to surround the concave portions (43a, 43b, 44a, 44b) in place of providing the elastic locking portions (61, 62).

The insides of the first member 41 and the second member 42 configuring the magnetic field sensor head 102 may be filled with the first magnetic material 30 and the second magnetic material 32, respectively. The first member 41 and the second member 42 may be formed by, for example, etching silicon. The first member 41 may be separated into a first member 401a on one side and a first member 401b on the other side and concave portions provided in both may respectively be filled with the first magnetic material 30. In other words, since the surface in which a concave portion is formed of the first member 401a on one side and the surface in which a concave portion is formed of the first member 401b on the other side are faced each other, a space for holding the first magnetic material 30 is formed by the concave portions. Similarly, the second member 42 may be separated into a second member 402a on one side and a second member 402b on the other side and concave portions provided in both may be respectively filled with the second magnetic material 32. The shape of the concave portions may be formed into an arbitrary shape and in accordance with the shape of the concave portions, the shape of the cross section cut by a plane perpendicular to the circumferential direction of the first magnetic material 30 and the second magnetic material 32 may be formed into the shape of a rectangle or circle.

After filling the concave portions with the first magnetic material 30, by integrating the first member 401a on one side and the first member 401b on the other side into one member, the first magnetic material 30 may be held in the first member 41. Similarly, after filling the concave portions with the second magnetic material 32, by integrating the second member 402a on one side and the second member 402b on the other side into one member, the second magnetic material 32 may be held in the second member 42.

As shown in FIG. 7, it is preferable for the first magnetic material 30 to have the first taper portion 31a and the second taper portion 31b formed so that the cross-sectional area perpendicular to the orientation of the magnetic flux 11 becomes smaller as they approach the magnetic film 1 in order to concentrate the magnetic flux 11 that occurs when a current flows through the conductor 10 on the area in which the magnetic film 1 is arranged. It is preferable for the magnetic film 1 to be formed in the vicinity of the vertex portion of each of the first taper portion 31a and the second taper portion 31b. In the vertex portion, the magnetic flux density is high compared to that in the other areas, and therefore much magnetic flux to the magnetic film 1 may be collected.

When a current flows through the conductor 10 in the direction perpendicular to the paper surface from the front side toward the rear side, the magnetic flux 11 occurs in the clockwise direction as shown by arrows in FIG. 7. It is preferable for the first magnetic material 30 and the second magnetic material 32 to be configured by a material whose relative permeability is higher than that of the first member 41 and the second member 42. The relative permeability is about 20, when the first magnetic material 30 and the second magnetic material 32 are configured by amorphous iron powder. The magnetic flux 11 that occurs around the conductor 10 is distributed in the first magnetic material 30 and the second magnetic material 32 whose relative permeability is high, and therefore the magnetic flux 11 concentrates on and is distributed in the area formed into the shape of a taper, if the first magnetic material 30 is formed into the shape of a taper.

For example, as shown in FIG. 7, when the first magnetic material 30 and the second magnetic material 32 are formed into the shape of a taper so that the cross-sectional area perpendicular to the orientation of the magnetic flux 11 becomes smaller toward the area in which the magnetic film 1 is arranged in the first taper portion 31a, the magnetic flux 11a in the first taper portion 31a converges more compared to the magnetic flux 11b before the first taper portion 31a. Thus, much magnetic flux on the magnetic film 1 may be concentrated by providing the first taper portion 31a.

Whereas only the magnetic flux reaching the area about the size of one optical fiber to the magnetic film is conventionally collected, according to the magnetic field sensor head 102 of the second embodiment of the present disclosure, the magnetic flux in a wider range to the magnetic film 1 may be collect, and therefore the amount of the measured magnetic flux may be increase and the accuracy of measurement may be improved.

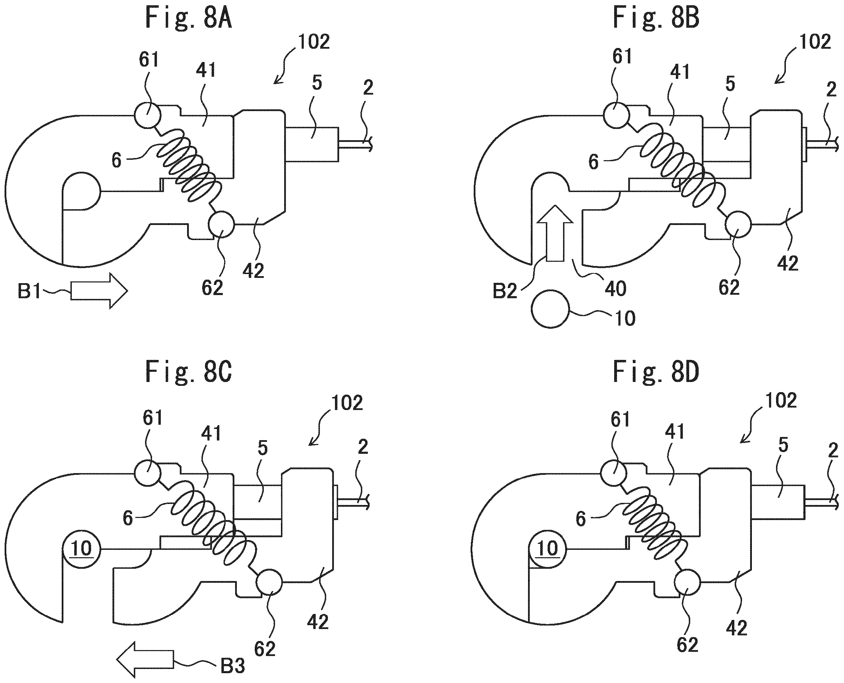

FIG. 8A to 8D show diagrams for explaining a procedure to insert the conductor 10 into the magnetic field sensor head 102 according to the second embodiment. FIG. 8A shows a first state, FIG. 8B shows a second state, FIG. 8C shows a third state, and FIG. 8D shows a fourth state. As one example, a case where the first member 41 is fixed and the second member 42 is slidable is explained. First, as shown in FIG. 8A, the second member 42 is moved in the direction of an arrow B1. At this time, as the second member 42 is moved, a force causing the elastic member 6 to return to the original shape is exerted.

Next, as shown in FIG. 8B, the gap 40 having a width greater than the diameter of the conductor 10 is formed between the first member 41 and the second member 42. At this time, the elastic member 6 extends and a force causing the elastic member 6 to return to the original shape is exerted, by moving the second member 42. Next, the conductor 10 is moved in the direction indicated by an arrow B2 and the conductor 10 is accommodated in the inner circumferential portion of the magnetic field sensor head 102.

Next, as shown in FIG. 8C, after the conductor 10 is accommodated in the inner circumferential portion of the magnetic field sensor head 102, the second member 42 is moved in the direction indicated by an arrow B3. At this time, the second member 42 may be moved by the restoring force occurred in the elastic member 6.

Next, as shown in FIG. 8D, the second member 42 is moved to the original position and the series of operations is completed. As shown in FIG. 7, the insides of the first member 41 and the second member 42 is filled with the first magnetic material 30 and the second magnetic material 32, and therefore the first magnetic material 30 and the second magnetic material 32 may be around the conductor 10.

Since the first member 41 or the second member 42 is movable, even if it is difficult to accommodate the conductor 10 in the inner circumferential portion of the magnetic field sensor head 102, such as a case where the conductor 10 is an already installed wire, the conductor 10 may be accommodated in the inner circumferential portion of the magnetic field sensor head 102 and the first magnetic material 30 and the second magnetic material 32 may be arranged around the conductor 10.

Although the example in which the first member 41 is fixed and the second member 42 slides is explained in the example shown in FIG. 8A to 8D, the example is not limited to the example shown therein. For example, the second member 42 may be fixed and the first member 41 may be slid, or both the first member 41 and the second member 42 may be slid.

## Claims

1. A magnetic field sensor head detecting a magnetic field occurring when a current flows through a conductor, comprising:
an optical fiber having a magnetic film arranged on the end surface and a reflective film arranged on the magnetic film; and
a magnetic material arranged in the form of a ring around a conductor and containing the magnetic film, wherein
the magnetic material includes a first taper portion formed so that a cross-sectional area perpendicular to the orientation of the magnetic flux becomes smaller as approaching the magnetic film in order to concentrate a magnetic flux occurring when a current flows through a conductor on an area in which the magnetic film is arranged.

2. The magnetic field sensor head according to claim 1, wherein
the first taper portion has a structure formed into the shape of a cone or a pyramid.

3. The magnetic field sensor head according to claim 1 or 2, wherein
the magnetic material includes amorphous iron powder solidified with resin.

4. The magnetic field sensor head according to any one of claims 1 to 3, wherein
the magnetic material further includes a second taper portion arranged facing the first taper portion and formed so that a cross-sectional area perpendicular to the orientation of the magnetic flux becomes smaller as approaching the magnetic film.

5. The magnetic field sensor head according to any one of claims 1 to 4, further comprising:
a first member and a second member holding the magnetic material, wherein
the first member and the second member are formed movable relatively so that a gap is formed between magnetic materials divided into plurality in order to arrange a conductor on the inner circumferential side of the magnetic materials.

6. The magnetic field sensor head according to claim 5, further comprising:
a support portion supporting the optical fiber, wherein
the first member and the second member fit to the support portion and
at least one of the first member and the second member is arranged slidable along the support portion.

7. The magnetic field sensor head according to claim 6, wherein
the first member and the second member are formed of silicon and
the support portion is formed of ceramics.

8. The magnetic field sensor head according to any one of claims 5 to 7, wherein
the first member and the second member are each provided with an elastic locking portion and
the elastic locking portion is provided with an elastic member on which a force causing the elastic member to return to the original position is exerted when the first member and the second member are slid relatively.

9. A magnetic field sensor device comprising:
the magnetic field sensor head according to any one of claims 1 to 8;
a light emitting device introducing linearly polarized light into an optical fiber as incident light; and
a light receiving device separating return light reflected from a reflective film and derived from the optical fiber into an S polarized light component and a P polarized light component, receiving the S polarized light component and the P polarized light component, converting the S polarized light component and the P polarized light component into electric signals, and processing the electric signals.
